# EUROPÄISCHE PATENTSCHRIFT

(11) **EP 0 357 918 B1**
(45) Veröffentlichungstag und Bekanntmachung des Hinweises auf die Patenterteilung: **24.11.1993**
(21) Anmeldenummer: 89113191.4
(22) Anmeldetag: 19.07.1989
(51) Int. Cl.: C23C 16/18, C23C 16/56

(54) **Verfahren zur haftfesten Abscheidung von Silberfilmen**
Process for depositing adherent silver films
Procédé de déposition de films d'argent adhérents

(30) Priorität: 16.08.1988 DE 3828211
(43) Veröffentlichungstag der Anmeldung: 14.03.1990
(73) Patentinhaber: ATOTECH Deutschland GmbH, 10553 Berlin (DE)
(72) Erfinder: Oehr, Christian, Dr., D-7403 Reusten (DE); Suhr, Harald, Prof. Dr., D-7400 Tübingen (DE)
(74) Vertreter: Effert, Udo, Dipl.-Ing.

(56) Entgegenhaltungen:
- EP-A- 0 027 625
- EP-A- 0 195 223
- EP-A- 0 297 348
- GB-A- 791 777
- JOURNAL OF THE ELECTROCHEMICAL SOCIETY, Band 119, Nr. 3, März 1972, Seiten 364-367, Manchester, US; R.J.H. VOORHOEVE et al.: "Selective deposition of silver on silicon by reaction with silver fluoride vapor"

## Beschreibung

Die Erfindung betrifft ein Verfahren zur haftfesten Abscheidung von Silberfilmen.

Die Abscheidung metallischer Filme auf nichtleitenden Substraten erfolgt in konventioneller Weise naßchemisch, indem die zu metallisierenden Teile mit speziell für ein Substrat formulierten Reinigungs-, Ätz-, Konditionierungs-, Aktivierungs- und Metallisierungsbädern behandelt werden. Hierbei wird die Oberfläche nach der Reinigung und Konditionierung zunächst mit edelmetallhaltigen Lösungen bekeimt und danach auf den aktivierten Flächen nach herkömmlichen Verfahren metallisiert.

Die Behandlungsbäder sind in der Regel wässrige Lösungen, enthalten zum Teil jedoch auch organische Lösungsmittel. Nachteil dieser Formulierungen ist die zum Teil hohe Toxizität bei erheblicher Flüchtigkeit der verwendeten Verbindungen, die entsprechende Sicherheitsvorkehrungen voraussetzt.

Ein weiterer wesentlicher Nachteil der naßchemischen Verfahren besteht darin, daß relativ komplizierte Vorbehandlungssequenzen vorzusehen sind, ehe metallisiert wird, um die gewünschten Haftungswerte zu erreichen. Dabei sind in jedem Falle die verfahrenstechnischen Parameter, wie zum Beispiel Temperatur und Behandlungszeit in engen Grenzen zu halten, so daß unter Umständen eine umfangreiche Prozeßkontrolle benötigt wird. Die Gefahr der Kontamination der Behandlungsbäder und hierdurch prozeßbedingte Verfahrensschwankungen zur Folge haben. Die Aggressivität der Behandlungslösungen wirkt sich unter Umständen qualitätsmindernd auf Abdecklacke oder -folien aus.

Weiterhin nachteilig ist der recht große Aufwand zur abwassertechnischen Behandlung der zahlreichen Behandlungsbäder und Spülwässer, da vielfach starkätzende oder schwermetallhaltige Elektrolyte eingesetzt werden.

Besonders schwerwiegend ist der nachteilige Umstand, daß umfangreiche Prozeßanpassungen erforderlich werden, wenn verschiedenartige Substrate metallisiert werden sollen. Die Anwendungsbreite der naßchemischen Verfahren ist in aller Regel so klein, daß unter Umständen sogar dann erhebliche Verfahrensänderungen nötig werden, wenn in einem organischen Polymersubstrat unterschiedliche Füllstoffmaterialien zum Einsatz kommen. Eine Übertragung der Prozeßparameter von einem zu beschichtenden Material auf ein anderes ist im Falle naßchemischer Metallisierungsverfahren nicht möglich.

Ein anderes bekanntes Abscheidungs- beziehungsweise Beschichtungsverfahren ist die thermische Zersetzung von flüchtigen Metallverbindungen. Innerhalb der EP-A1-0297 348 wird u. a. die thermische Zersetzung von Silbercyclopentadienyl beschrieben. Dieses Verfahren setzt sehr hohe Substrattemperaturen von mindestens 200° C bis zu 1000° C voraus, die aber für viele Materialien nicht oder nur unter der Gefahr der Materialschädigung erreicht werden dürfen. Die EP-A1-0297 348 stellt eine ältere jedoch nachveröffentlichte Schriftdar, die nur bei der Neuheitsprüfung zu berücksichtigen ist.

Innerhalb der EP-A1-27 625 wird ebenfalls die thermische Zersetzung von Silberverbindungen und die anschließende Metallisierung von Polyolefinen beschrieben, jedoch ohne Anwendung einer Glimmentladungszone.

Aufgabe der vorliegenden Erfindung ist daher die Bereitstellung eines Verfahrens, welches die haftfeste Abscheidung von Silberfilmen bei relativ niedrigen Temperaturen, in Abwesenheit von Lösungsmitteln und unter Anwendung einer Glimmentladungszone ermöglicht.

Diese Aufgabe wird erfindungsgemäß durch ein Verfahren gemäß dem kennzeichnenden Teil des Patentanspruchs gelöst.

Weitere Ausgestaltungen der Erfindung sind den Kennzeichnungsteilen der Unteransprüche zu entnehmen.

Die erfindungsgemäß mit einem Silberfilm beschichteten Materialien werden als Halbzeuge in der Elektronikindustrie, zum Beispiel für die Herstellung von elektrischen Kontakten auf isolierenden Substraten eingesetzt. Andere Anwendungsbereiche nutzen die vorteilhaften optischen Eigenschaften des Silbers als guten Reflektor. Silber kann vorteilhaft als reflektierendes Metall bei der Spiegelherstelung oder in optischen Speichermedien, wie zum Beispiel Compact Discs, eingesetzt werden. Darüberhinaus sind auch dekorative Anwendungen möglich. Für alle Anwendungen ist ein haftfester Verbund zwischen Unterlage und Silber erfoderlich. Zum Teil werden ganzflächig metallisierte Halbzeuge erfordert, teilweise , wie in der Anwendung in der Elektronikindustrie, wird eine partielle Metallisierung gewünscht. Außerdem kann eine dünne Silberschicht auch als Aktivator für eine nachfolgende zu applizierende stromlose oder galvanische Metallisierung, zum Beispiel mit stromlos arbeitenden Kupfer-, Nickel-, Gold-, Zinn- oder anderen Elektrolyten aufgebracht werden.

Das erfindungsgemäße Verfahren vermeidet die Nachteile der bekannten Verfahren, indem der naßchemische Arbeitsablauf vermieden wird. Erfindungsgemäß wird die Abscheidung der Silberfilme aus der Gasphase durch Zersetzung von 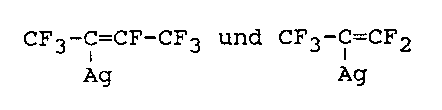
und Pentafluorphenylsilber in einem Plasma vorgenommen. Hierbei werden, je nach Behandlungszeit, Schichten von ca. 10 nm bis etwa 200 nm erhalten, die gegebenenfalls anschließend - ohne weitere Vorbehandlung - vorzugsweise in einem chemischen Kupfer-, Gold-, Zinn- oder Nickelbad oder nach einer Metallisierung in einem chemischen Bad, in einem galvanischen Bad, vorzugsweise einem Kupfer-, Nickel-, Gold-, Palladium-oder Chrombad bis zur gewünschten Schichtstärke verstärkt werden können.

Im Fall dickerer, nach dem erfindungsgemäßen Verfahren hergestellter, zusammenhängender Metallschichten kann es auch vorteilhaft sein, eine galvanische Metallisierung direkt anzuschließen.

Eine Erzeugung metallischer Strukturen kann hierbei nach einem der bekannten Verfahren (Additiv-, Semiadditiv-, Substraktivtechnik) erfolgen, zum Beispiel indem die Substratoberfläche während der Metallisierung durch eine Maske abgedeckt wird, so daß lediglich die Stellen freigelassen werden, die die metallischen Strukturen tragen sollen.

Andere Ausführungsformen der Strukturierung, zum Beispiel mit Hilfe von Siebdrucklacken, Fotolacken oder Fotoresistfilmen können ebenfalls eingesetzt werden.

Die erfindugsgemäß zu verwendenden flüchtigen Silberverbindungen sind an sich bekannt oder können nach an sich bekannten Verfahren hergestellt werden.

In das Verfahren können perfluorierte silberorganische Verbindungen, bei denen Silber an das an einer CC-Doppelbindung liegende Kohlenstoffatom gebunden ist, eingesetzt werden . Vorteilhaft einssetzbar sind die Verbindungen 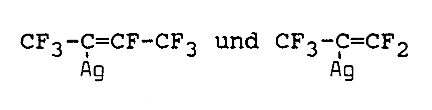
und
Pentafluorphenylsilber.
Die Filmabscheidung erfolgt in normalen Plasmareaktoren, die hauptsächlich als Rohr- oder Tunnelreaktoren oder als Parallelplattenreaktoren für Coronaentladungen bekannt sind. Für die Herstellung dieser metallischen Filme und Strukturen kann das Plasma sowohl mit Gleichstrom als auch mit Wechselstrom oder Hochfrequenz (inklusive Mikrowellen), im allgemeinen im kHz- oder MHz-Bereich erzeugt werden. Der Druck in der Plasmakammer beträgt 0,2 - 1,0 hPa. Als Substrate kommen beispielsweise organische Polymere sowie anorganische Materialien wie Keramiken (Al₂O₃, AlN, BN,W₂C, B₄C, und andere) und Quarz beziehungsweise Quarzglas und deren Mischungen in den verschiedensten Ausführungsformen zum Einsatz: als Platten, dreidimensionale Formkörper oder Folien, mit oder ohne Füllstoffe, einschichtig oder mehrschichtig. Weiterhin sind zu nennen in der Elektronikindustrie verwendete Mehrlagenschaltungen, die aus einem Schichtaufbau von Kupferlagen alternierend mit Isoliermaterialien bestehen .

Die erfindungsgemäß verwendeten Silberverbindungen werden dem Plasmareaktor gasförmig zugeführt, vorzugsweise durch Sublimation oder Verdampfung. Sie können für sich allein benutzt werden, jedoch vorteilhafterweise auch verdünnt mit Trägergasen, um gleichmäßige porenfreie Schichten zu erhalten. Als Trägergase eignen sich inerte Gase, wie Argon oder Helium, oder reduzierende Gase, wie Wasserstoff; auch Gemische können eingesetzt werden. Die Einspeisung der Silberverbindungen erfolgt nach Einstellung des Vakuums außerhalb der Glimmentladungszone in den Strom des Trägergases, so daß im eigentlichen Reaktionsbereich eine gleichmäßige Gasmischung vorliegt. Der Vorratsbehälter für die Metallverbindung wird zweckmäßigerweise mit einer Vorrichtung zum Heizen versehen, um schwerere sublimierbare Metallverbindungen in ausreichender Menge in den Gasstrom zu führen.

Eine besondere Ausführungsform des erfindungsgemäßen Verfahrens besteht darin, daß vor dem Metallisierungsprozeß in der Plasmaentladung ein Plasmaätzprozeß vorgenommen wird, um die Substratoberfläche zu reinigen und für die Aufnahme der Metallschicht empfänglich zu machen. Die Ausführungsform des Reaktors und der Verfahrensbedingungen unterscheiden sich im Prinzip nicht von dem Plasma-Metallisierungsprozeß.

Es versteht sich, daß beim Plasma-Ätzprozeß keine metallorganischen Verbindungen verwendet wurden. Vorteilhafter- weise können dem inerten Trägergas reaktive Gase, wie zum Beispiel Sauerstofff oder Tetrafluormethan-Sauerstoff, zugesetzt werden.

Als weitere geeignete Substrate für die erfindungsgemäße Silberfilmabscheidung sind zum Beispiel Glas, Keramik, PTFE und Metalle, wie Aluminium, zum Beispiel Aluminiumelektroden, zu nennen.

Das folgende Beispiel dient der Erläuterung der Erfindung.

### BEISPIEL

| | |
|---|---|
| Reaktortyp | Parallelplattenreaktor |
| Frequenz | 13,56 MHz |
| Substrat | Glasplättchen 50 x 50 mm |
| Substrattemperatur | 120° C |

Die Apparatur wurde vor dem Versuch auf einen Druck P < 10 Pa leergepumpt. Dann wurden 15 Pa Argon und 10 Pa Wasserstoff in das Arbeitsabteil eingelassen. Aus einem auf 90 - 95° C erwärmten Vorratsgefäß wurde CF₃- CAg = CF - CF₃ in das Arbeitsabteil sublimiert und unter ständigem Argon/Wasserstoff-Strom nachgeführt. Das Plasma wurde bei einer Leistung von 45 Watt betrieben. Die Abscheidungsgeschwindigkeit beträgt ca. 4nm/min (40 Å/min).

Man erhält einen hochglänzenden gut haftenden Silberspiegel mit einer spezifischen Leitfähigkeit von ca. 4.10⁵ S.cm⁻¹.

## Patentansprüche

1. Verfahren zur haftfesten Abscheidung von Silberfilmen, dadurch gekennzeichnet, daß die Abscheidung in einer Glimmentladungszone aus halogenhaltigen Silberverbindungen in der Gasphase erfolgt, in denen die Silberatome an sp² - hybridisierte Kohlenstoffatome gebunden sind.

2. Verfahren gemäß Anspruch 1, dadurch gekennzeichnet, daß als Silberverbindungen 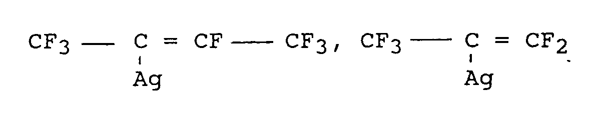 oder
Pentafluorphenylsilber
eingesetzt werden.

3. Verfahren gemäß Anspruch 1 oder 2, dadurch gekennzeichnet, daß zusätzlich Trägergase verwendet werden.

4. Verfahren gemäß Ansprüche 1 - 3, dadurch gekennzeichnet, daß der Silberfilm chemisch reduktiv und/oder galvanisch verstärkt wird.

5. Verfahren gemäß Anspruch 4, dadurch gekennzeichnet, daß vorzugsweise ein chemisch reduktives Kupfer- oder Nickelbad verwendet wird.

6. Verfahren gemäß Ansprüche 1 - 5, dadurch gekennzeichnet, daß die Abscheidung der Silberfilme auf Nichtleitern oder leitenden Oberflächen erfolgt.

## Claims

1. Method for the firmly adhesive deposition of silver films, characterised in that the deposition is effected in a glow discharge zone from halogen-containing silver compounds in the gas phase, in which compounds the silver atoms are combined with sp²-hybridised carbon atoms.

2. Method according to claim 1, characterised in that 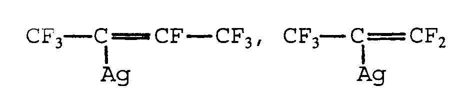 or
pentafluorophenyl silver are used as silver compounds.

3. Method according to claim 1 or 2, characterised in that carrier gases are additionally used.

4. Method according to claims 1 to 3, characterised in that the silver film is electrolessly and/or electrolytically reinforced.

5. Method according to claim 4, characterised in that an electroless copper or nickel bath is preferably used.

6. Method according to claims 1 to 5, characterised in that the deposition of the silver films is effected on non-conductors or on conductive surfaces.

## Revendications

1. Procédé de déposition par adhésion de films d'argent, caractérisé en ce que, la déposition est effectuée, en phase gazeuse, dans une zone de décharge lumineuse, à partir de combinaisons d'argent halogénées dans lesquelles les atomes d'argent sont liés aux atomes de carbone hybridés - sp².

2. Procédé selon la revendication 1, caractérisé en ce que l'on utilise, en tant que combinaisons d'argent, du 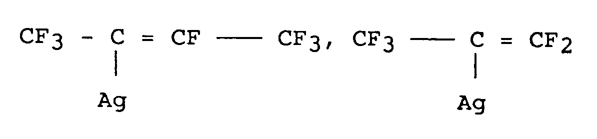 ou
du pentafluorphénylargent.

3. Procédé selon la revendication 1 ou la revendication 2, caractérisé en ce que l'on utilise, en outre, des gaz porteurs.

4. Procédé selon les revendications 1 à 3, caractérisé en ce que le film d'argent est renforcé par réduction chimique et/ou par galvanoplastie.

5. Procédé selon la revendication 4, caractérisé en ce que l'on utilise, de préférence, un bain au cuivre ou un bain au nickel chimiquement réducteur.

6. Procédé selon les revendications 1 à 5, caractérisé en ce que la déposition des films d'argent est effectuée sur des isolants ou sur des surfaces conductrices.
